# EUROPEAN PATENT SPECIFICATION

(11) **EP 2 807 906 B1**
(45) Date of publication and mention of the grant of the patent: **21.11.2018**
(21) Application number: 13701755.4
(22) Date of filing: 24.01.2013
(51) Int. Cl.: H05K 3/12, B41F 15/36, B41N 1/24

(54) **PRINTING SCREEN FOR SURFACE MOUNT DEVICES**
DRUCKSCHABLONE FÜR OBERFLÄCHENMONTAGEVORRICHTUNGEN
ÉCRAN D'IMPRESSION POUR DISPOSITIFS DE MONTAGE EN SURFACE

(30) Priority: 26.01.2012 ES 201230107
(43) Date of publication of application: 03.12.2014
(73) Proprietor: Ibil Laser S.L., 20018 San Sebastian (ES)
(72) Inventor: BERAZA ERCILBENGOA, Iker, E-20100 Errenteria (ES)
(74) Representative: Igartua, Ismael
(86) International application number: PCT/EP2013/051295
(87) International publication number: WO 2013/110685

(56) References cited:
- WO-A2-2011/120700
- US-A1- 2006 005 721
- US-A1- 2009 217 831

## Description

### TECHNICAL FIELD

The present invention relates to printing screens for surface mount devices, also called SMDs, which are used in screen printing machines.

### PRIOR ART

Printing screens or stencils traditionally comprise a sheet including openings which define a pattern on which a printing material is applied by means of a screen printing process. Such screens are used extensively in printed circuit boards or PCBs, the printing screen being used to apply solder paste on the printed circuit boards, the surface mount devices subsequently being fixed on said paste. The printing screens are fixed to stretching devices so that movements of the printing screen, which would render the printed circuit board useless, do not occur during the process of screen printing. To that end, printing screens are stretched during the screen printing process.

Printing screens comprising a frame surrounding the sheet and on which tension is applied are known for correctly applying tension. The sheet is fixed to the frame by means of a flexible mesh generally made of propylene. The stretching device stretches the sheet through the frame and the flexible mesh. Such printing screens take up considerable space and require a laborious prior preparation.

On the other hand, stencils having holes which are positioned in projections projecting from rulers the stencil being stretched by means of the ruler as described in ES2146889T3 are known.

EP1651019B1 describes a printing screen having the bent sides suitable for the direct coupling to engagement means of a fastening device. The printing screen further includes cuts in the middle of at least two opposite sides of the printing screen.

WO2011120700A2 discloses a printing screen for surface mount devices, comprising a sheet having bent sides arranged substantially parallel to one another, configured for being fastened directly to a stretching device for stretching the printing screen.

US2006/0005721A1 discloses a printing screen for surface mount devices, comprising a sheet having bent sides arranged substantially parallel to one another, configured for being fastened directly to a stretching device for stretching the printing screen, the printing screen comprising on each bent side a protective element comprising a side covering each bent side of the sheet, and securing means arranged in the first protective element or in the bent side of the sheet configured for holding the printing screen against the stretching device and for centering the printing screen with respect to the tension device.

### DESCRIPTION OF THE INVENTION

The object of the invention is to provide a printing screen for surface mount devices. The printing screen is particularly suitable for creating a desired pattern on a PCB when printing a solder paste on said printing screen in a screen printing machine, the surface mount devices being fixed according to the pattern.

The printing screen according to the invention comprises a sheet having at least two bent sides arranged substantially parallel to one another, suitable for being fastened directly to a stretching device for stretching the printing screen. Bending the sides provides stiffness to the printing screen.

The printing screen comprises on each bent side a first protective element comprising a side at least partially covering each bent side of the sheet and securing means arranged in the protective element or in the bent side of the sheet configured for holding the printing screen against the stretching device and centering the printing screen with respect to the stretching device.

The securing means of the printing screen configure a substantially V-shaped geometry together with the bent side or together with the first protective element. Said securing means comprise a prolongation extending as a continuation of the corresponding bent side or extending as a continuation of the side of the first protective element. The side of the first protective element is arranged substantially parallel to the bent side of the sheet when the prolongation extends as a continuation of the side of the first protective element. The angle formed by the prolongation together with the bent side is an angle between approximately 75° and approximately 130°, said prolongation being configured for preventing an incorrect mounting of the printing screen in the stretching device.

The printing screen obtained allows the direct transmission of the tension from the stretching device to the sheet since the sheet is coupled directly to the stretching device, said transfer therefore being more effective.

On the other hand, the securing means provide a secure clamping of the stencil to the stretching device. Therefore, if the operation of the stretching device fails due to a breakdown, blows, etc., for example, the printing screen would remain fastened to the tension device. The securing means further provide a simple self-centering system of the printing screen with respect to the stretching device. Therefore, the operator does not have to waste time in correctly positioning the stencil with respect to the stretching device given that the securing means force the stencil to be positioned correctly. When the user arranges the stencil on the stretching device, applying substantially orthogonal pressure thereon is sufficient, the stencil being clamped to the stretching device. The securing means do not allow clamping the printing screen unless it is correctly positioned with respect to the stretching device.

On the other hand, the protective element on one hand protects the operator from cuts when handling the printing screen, and on the other hand provides stiffness to said printing screen. The protective element together with the securing means further facilitates aligning the printing screen with respect to the stretching device, assuring a correct insertion thereof. Situations in which only one of the bent sides has been correctly fastened to the stretching device are thereby prevented.

Finally, the printing screen obtained takes up little space, is robust, can be easily handled, and is optimized with respect to the number of necessary parts.

These and other advantages and features of the invention will become evident in view of the drawings and the detailed description of the invention.

### DESCRIPTION OF THE DRAWINGS

Figure 1 shows a perspective view of a first embodiment of a printing screen according to the invention prior to being assembled in a stretching device.
Figure 2 shows a perspective view of the first embodiment of the printing screen shown in Figure 1 assembled in the stretching device.
Figure 3 shows an exploded view of the printing screen shown in Figure 1.
Figure 4 shows a partial cross-section view of the first embodiment of the printing screen shown in Figure 1.
Figure 5(a) shows the printing screen shown in Figure 4 prior to being assembled in the stretching device.
Figure 5(b) shows the printing screen shown in Figure 4 once assembled in the stretching device.
Figure 6 shows a partial cross-section view of a second embodiment of the printing screen shown in Figure 1.
Figure 7(a) shows a partial cross-section view of the printing screen shown in Figure 6 prior to being assembled in the stretching device shown in Figure 1.
Figure 7(b) shows a partial cross-section view of the printing screen shown in Figure 6 once assembled in the stretching device shown in Figure 1.
Figure 8 shows a system for storing several printing screens according to the invention.

### DETAILED DESCRIPTION OF THE INVENTION

The printing screen 1 according to the invention is suitable for surface mount devices, also referred to as SMDs, which are mounted on a surface of a printed circuit board or PCB by means of surface mount technology also referred to as SMT. The printing screen 1 is particularly suitable for creating a desired pattern on a PCB when printing a solder paste on said printing screen 1 in a screen printing machine, the SMDs being fixed according to the pattern.

The printing screen 1 comprises a sheet 2 having a thickness between approximately 0.01 mm and approximately 1.00 mm. In the embodiments shown in the drawings, the sheet 2 is metallic, preferably made of stainless steel or nickel. In other embodiments not shown, the sheet 2 could be made of plastic.

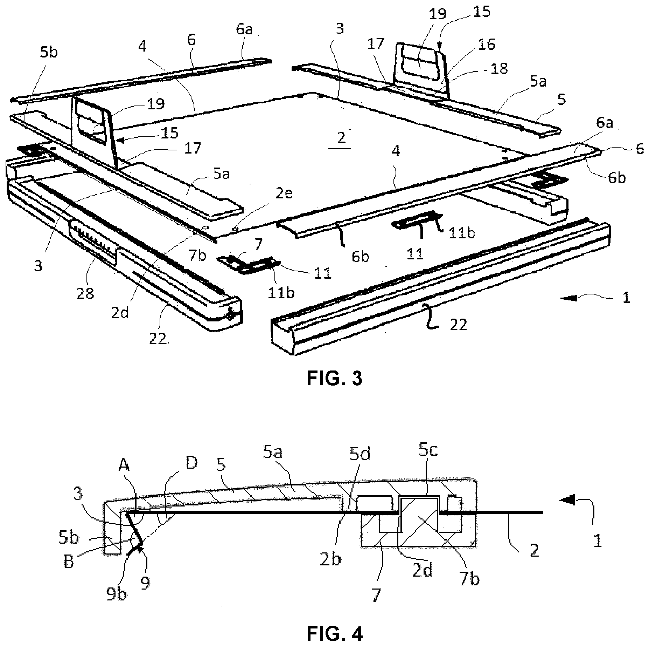

In the embodiments shown in the drawings, the sheet 2 has a substantially rectangular geometry and comprises two bent sides 3 substantially parallel to one another along the entire length, as shown in Figures 3, 4(a), 4(b), 5(a), 5(b), 6, 7(a) y 7(b), and two non-bent sides 4 substantially parallel to one another. The bent sides 3 provide stiffness to the printing screen 1 in the direction of the bend.

The printing screen 1 comprises first protective elements 5, each of which is arranged fixed to the bent side 3 of the sheet 2 and which stiffen the sheet 2 in the direction of the first protective element 5 in addition to protecting the operator from cuts when handling the sheet 2. To that end, each first protective element 5 comprises a side 5b at least partially covering each bent side 3. The first protective elements 5 can be fixed to the sheet 2 by deep drawing, gluing, clipping or other known fastening means.

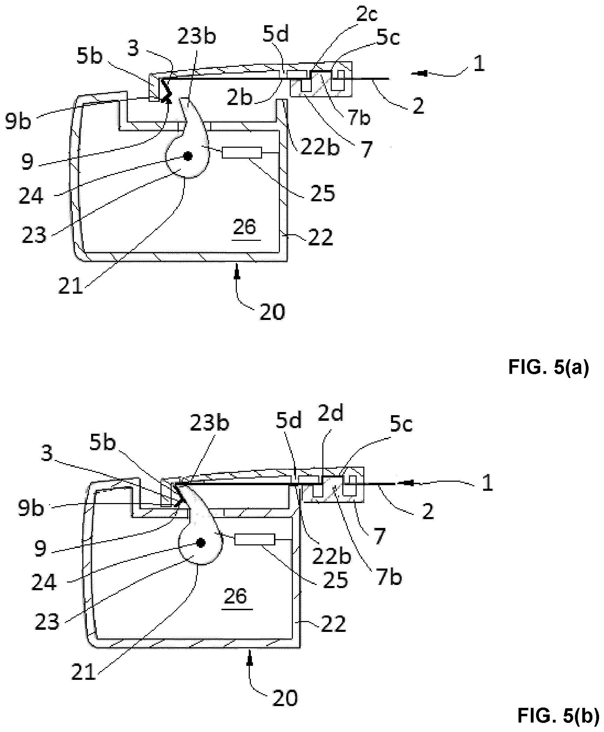

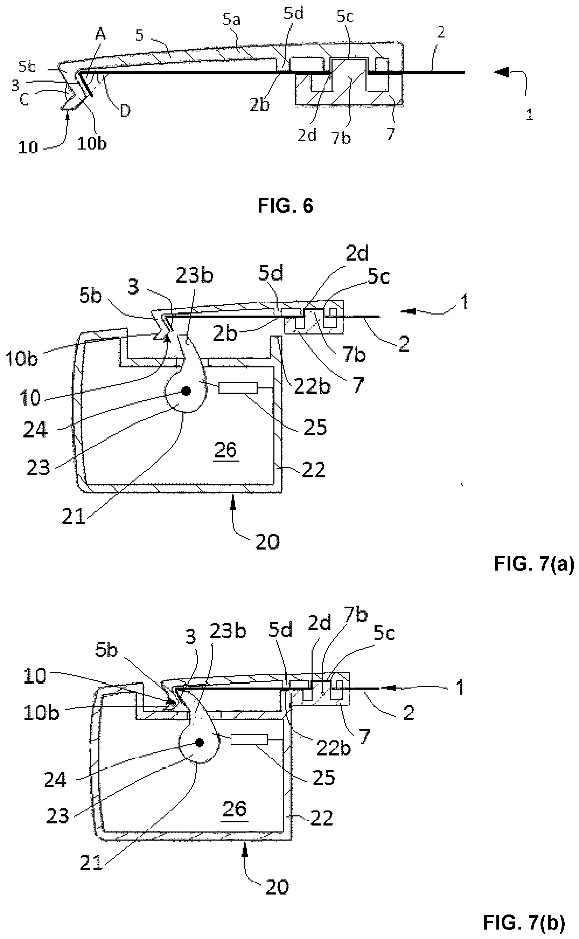

Furthermore, the printing screen 1 is suitable for being coupled to a stretching device 20 which tenses said printing screen 1 so that it can be correctly printed on in a screen printing machine not shown. The stretching device 20 comprises a frame 22 suitable for supporting the printing screen 1 and actuation means 21 shown in Figures 5(a), 5(b), 7(a) and 7(b) which act directly on the bent sides 3 of the sheet 2 by stretching it, such that tension is transmitted to the sheet 2 in a much more effective manner given that a direct transmission of stresses from the actuation means 21 to the sheet 2 occurs. The actuation means 21 can be operated by hydraulic, electric, mechanical or pneumatic means, and can include an oil chamber, batteries or an air chamber, respectively.

In the embodiments shown in Figures 4, 5(a), 5(b), 6, 7(a), and 7(b), each bent side 3 forms an angle A with the sheet 2, said angle A being suitable for engaging the stretching device 20. Said angle A is an acute angle between approximately 30° and approximately 85°.

In the embodiments not shown in the drawings, instead of forming an acute angle with the substantially planar part of the sheet, each bent side can have a geometry with a substantially C-shaped cross-section towards the inside of the sheet, said geometry being able to be substantially straight or curved.

In the depicted embodiments, the actuation means 21 comprise actuators 23 and elastic means 25 regulating the rotation of the corresponding actuator 23. The actuators 23 are arranged substantially parallel to one another, each of them being partially housed inside a cavity 26 comprised in the frame 22, being suitable for rotating with respect to a respective shaft 24 housed inside the cavity 26. Each actuator 23 comprises an end that is suitable for gripping the bent side 3.

In other non-depicted embodiments, the actuation means 21 can comprise an actuator which rotates with respect to the cavity comprised in the frame instead of rotating with respect to a physical shaft. To that end, the actuator has an end with a substantially circular section housed inside the cavity which is delimited by a substantially circular surface, said cavity cooperating with the end of the actuator for the rotation thereof.

On the other hand, the elastic means 25 comprise a compression spring fixed at one end to the frame 22 and at the other end to the actuator 23. The spring keeps one end 23b of the actuator 23 which extends outside the cavity 26 against the bent side 3 of the sheet 2. The end 23b of the actuator 23 is suitable for engaging the corresponding bent side 3 and stretching the printing screen 1.

The printing screen 1 according to the invention comprises securing means 9,10 suitable for holding said printing screen 1 against the tension device 20. The printing screen 1 is thereby prevented from being released from said actuation means 21 in the event that the operation of the actuation means 21 fails for any reason. Furthermore, the securing means 9,10 assure the correct positioning of the printing screen 1 with respect to the stretching device 20. The securing means 9,10 center the printing screen 1 with respect to the actuators 23 in a simple and quick manner.

The securing means 9,10 are arranged in the first protective element 5 or in the bent side 3 of the sheet 2. The securing means 9,10 furthermore extend as a continuation of the first protective element 5 or of the bent side 3 of the sheet 2 forming an acute angle D with respect to the sheet 2, particularly with respect to the substantially planar part of the sheet 2, as shown in figures 4 and 6. The angle D formed by the securing means 9,10 with respect to the sheet 2 is between approximately 15° and approximately 100°.

In a first embodiment of the invention shown in detail in Figures 4, 5(a) and 5(b), the printing screen 1 comprises the securing means 9 arranged in the bent side 3 suitable for holding the printing screen 1 against the stretching device 20. The securing means 9 together with the bent side 3 of the sheet 2 configure a substantially V-shaped geometry, forming an angle B between both. The securing means 9 comprise a prolongation 9b extending as a continuation from the corresponding bent side 3. The angle B formed by the prolongation 9b together with the bent side 3 is an angle between approximately 75° and approximately 130°. The prolongation 9b is metallic, preferably made of stainless steel. This prolongation 9b acts as a guide, guiding the insertion of the stencil 1 in the corresponding actuator 23 for the corresponding fastening of the stencil 1 to the actuation device 20, the prolongations 9b preventing an incorrect mounting of the stencil 1 in the actuation device 20.

In a second embodiment of the invention shown in detail in Figures 6, 7(a) and 7(b), the securing means 10 are arranged in the first protective element 5 which hold the printing screen 1 against the stretching device 20. The securing means 10 together with the bent side 3 of the sheet 2 configure a substantially V-shaped geometry, defining an angle C. In this embodiment, side 5b of the first protective element 5 is arranged substantially parallel to the bent side 3 of the sheet 2, the securing means 10 comprising a prolongation 10b extending as a continuation from the corresponding side 5b, the prolongation 10b and the side 5b configuring the substantially V-shaped geometry. The angle C formed by the prolongation 10b together with the side 5b of the first protective element 5 is an angle between approximately 75° and approximately 135°. The prolongation 10b is furthermore made of plastic, preferably thermoplastic, injected together with the side 5b. This prolongation 10b acts as a guide, guiding the insertion of the stencil 1 in the corresponding actuator 23 for the corresponding fastening of the stencil 1 to the actuation device 20, the prolongations 10b preventing an incorrect mounting of the printing screen 1 in the actuation device 20.

On the other hand, in both embodiments shown in the drawings each first protective element 5 comprises a base 5a which is arranged on the sheet 2, the side 5b that is a continuation of the base 5a extending on the bent side 3 of the sheet 2, at least partially covering said bent side 3.

In the embodiments shown, the first protective element 5 extends longitudinally along the bent side 3 of the sheet, covering the bent side 3. Particularly in the first embodiment, the side 5b of the first protective element 5 extends substantially orthogonal to the base 5a, covering the bent side 3 and the prolongation 9b.

On the other hand, in both embodiments the first protective element 5 comprises at least one reinforcement 7 providing greater stiffness to the first protective element 5. Each reinforcement 7 is arranged facing the base 5a and fixed to said base 5a, the sheet 2 being arranged between both.

Each reinforcement 7 comprises at least one projection 7b passing through a hole 2d of the corresponding sheet 2 shown in figures 4 and 6, cooperating with a housing 5c comprised in the base 5a for fixing the reinforcement 7 to the base 5a.

In the embodiment shown in the drawings, each first protective element 5 comprises several longitudinally distributed reinforcements 7.

On the other hand, the sheet 2 rests on the stretching device 20 along at least one support area 2b shown in figures 4 and 6. Particularly, the sheet 2 rests on a surface 22b of the frame 22, shown in figures 5(a), 5(b), 7(a) y 7(b), the support area 2b being minimal. Each first protective element 5 further comprises a projection 5d extending from the base 5a towards the corresponding sheet 2, the projection 5d at least partially resting on the support area 2b of the sheet 1. The stiffness of the printing screen 1 is thus increased.

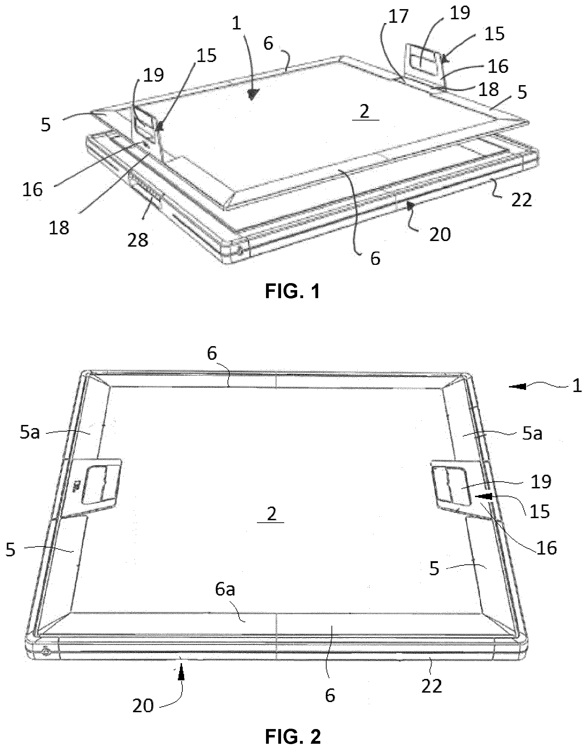

In the embodiment shown in Figures 1 to 3, the printing screen 1 comprises second protective elements 6 at least partially covering each non-bent side of the sheet 2. These second protective elements 6 provide additional stiffness to the printing screen 1 comprising the first protective elements 5 in the direction of the second protective element 6 in addition to protecting the operator from cuts when handling the sheet 2. In the embodiment shown in the drawings, each second protective element 6 extends longitudinally along the non-bent side 4. Each second protective element 6 comprises a base 6a which is arranged on the sheet 2, a side 6b shown in figure 1 covering the non-bent side 4, and a reinforcement 11 providing greater stiffness to the second protective element 6. Each reinforcement 11 is arranged facing the base 6a and fixed to said base 6a, the sheet 2 being arranged between both.

Each reinforcement 11 comprises at least one projection 11b passing through a hole 2e of the sheet 2 cooperating with a housing, not shown, comprised in the base 6a for fixing the reinforcement 11 to the base 6a.

Each second protective element 6 further comprises a projection not shown, similar to the projection of the first protective element extending from the base 6a towards the sheet 2, the projection at least partially resting on the support area 2b of the sheet 1, increasing the stiffness of the printing screen 1.

The printing screen 1 of the second embodiment comprises second protective elements not shown in figures, of the same characteristics as those described for the first embodiment.

In the embodiments shown in the drawings, the reinforcements 7,11 of the protective elements 5,6 are made of a thermosetting plastic, although in other embodiments they could be made of other plastic, metallic or elastomeric materials. Furthermore, in the embodiments shown in the drawings the reinforcements 7,11, which are arranged at the ends of the respective protective elements 5,6, form a single part in the form of a square.

On the other hand, the printing screen 1 further comprises handling means 15 through which the user can handle the stencil 1 and store it in a quick and ergonomic manner. The handling means 15 comprise at least one handle 16 arranged in one of the protective elements 5,6. The handle 16 is arranged substantially centered with respect to the corresponding protective element 5,6 and is collapsible with respect to said protective element 5,6.

In the embodiment shown in the drawings, the protective element 5,6 comprises a recess 17, shown in Figures 1, 3 and 8, such that once the stencil 1 is assembled in the stretching device 20, the handle 16 is arranged in a collapsed position, at least partially housed in the recess 17 taking up minimum space, as shown in Figure 2, and when the stencil 1 has to be handled by the operator, the handle 16 is arranged in a position substantially orthogonal to the stencil 1, as shown in Figures 1 and 3, such that it is substantially aligned with the substantially vertical movement which the operator must make to assemble or extract the printing screen 1 on/from the stretching device 20.

In other not shown embodiments, particularly in those cases in which it is necessary to completely release the stencil 1, the handle 16 can be collapsed in the opposite direction, towards the outside of the stencil 1. The handle 16 would be retractable, for which purpose the frame 22 of the tension device 22 would comprise housings in which the collapsed handle 16 would be housed.

On the other hand, the frame 22 of the stretching device 20 comprises at least one housing 28, shown in figures 1 and 3, in each one of two of the faces of the frame 22 arranged facing one another which is suitable so that the operator can handle the stretching device 20 with the printing screen 1 assembled therein.

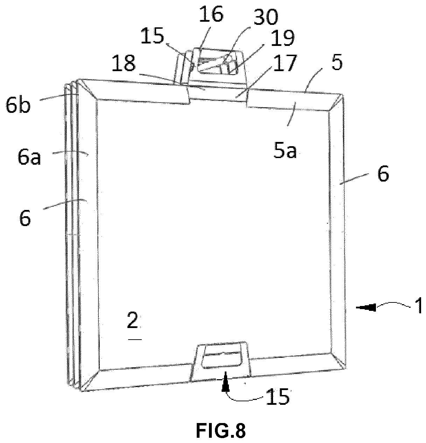

In the embodiments shown in Figures 1 to 3 and in Figure 8, the handling means 15 comprise two handles 16 each arranged in the respective first protective element 5. Each handle 16 is further integrated in each first protective element 5. The handle 16 shown in the embodiment is made of a thermoplastic injected together with the first protective element 5. Each handle 16 is attached in a continuous manner to the corresponding first protective element 5 through a bend line 18, shown in Figures 1, 3 and 8, acting as a hinge, the handle 16 being able to be collapsed with respect to said bend line 18. In other not shown embodiments, each handle 16 can be made of other plastic, elastomeric or metallic materials. Each handle 16 can further comprise a shaft which is arranged inserted in a respective cavity arranged in the first protective element 5 such that said shaft acts as a hinge being able to rotate in the cavity with respect to the corresponding first protective element 5.

In other not shown embodiments, each handle 16 could include at least one magnet to keep the corresponding handle 16 collapsed against the sheet 2 or against the frame 22 of the stretching device 20 when necessary.

In other not shown embodiments, the handle can be detachable.

On the other hand, at least one handle 16 can be used to hang the printing screen 1, as shown in Figure 6. The printing screens 1 can therefore be stored vertically, hung on a wall such that they take up little space. Each handle 16 comprises an opening 19 allowing the operator to grip the handle 16 for handling the printing screen 1 and through which the stencil 1 is hung on a projection 30 fixed to the wall or in other known storage systems.

On the other hand, although in the embodiments shown in the drawings the sheet 2 comprises two bent sides 3 arranged parallel to one another, such that the stretching device 20 tenses the sheet 2 longitudinally in a direction substantially orthogonal to the two bent sides 3, in other embodiments not shown in the drawings the sheet 2 can comprise four bent sides, the stretching device 20 being able to stretch the sheet 2 longitudinally and transversely, in two directions substantially orthogonal to one another.

Finally, in other not shown embodiments, the sheet 2 can have another type of polygonal geometry, e.g., it can be substantially square.

## Claims

1. A printing screen for surface mount devices, comprising a sheet (2) having at least two bent sides (3) arranged substantially parallel to one another, configured for being fastened directly to a stretching device (20) for stretching the printing screen (1), the printing screen (1) comprising on each bent side (3) a first protective element (5) comprising a side (5b) at least partially covering each bent side (3) of the sheet (2), and securing means (9,10) arranged in the first protective element (5) or in the bent side (3) of the sheet (2) configured for holding the printing screen (1) against the stretching device (20) and for centering the printing screen (1) with respect to the stretching device (20), **characterized in that** the securing means (9,10) configure a substantially V-shaped geometry together with the bent side (3) or together with the first protective element (5), said securing means (9,10) comprising a prolongation (9b,10b) extending as a continuation of the corresponding bent side (3) or extending as a continuation of the side (5b) of the first protective element (5), the side (5b) of the first protective element (5) being arranged substantially parallel to the bent side (3) of the sheet (2) when the prolongation (10b) extends as a continuation of the side (5b) of the first protective element (5), the angle (B,C) formed by the prolongation (9b,10b) together with the bent side (3) being an angle between approximately 75° and approximately 130°, said prolongation (9b,10b) being configured for preventing an incorrect mounting of the printing screen (1) in the stretching device (20).

2. The printing screen according to claim 1, wherein the securing means (9,10) form an angle (D) with the sheet (2) between approximately 15° and approximately 100°.

3. The printing screen according to claims 1 or 2, wherein each bent side (3) forms an acute angle (A) with the sheet (2) between approximately 30° and approximately 85°.

4. The printing screen according to any of the preceding claims, wherein the first protective element (5) comprises a base (5a) which is arranged on the sheet (2), the side (5b) that is a continuation of the base (5a) being arranged on the corresponding bent side (3) of the sheet (2), at least partially covering said bent side (3).

5. The printing screen according to the preceding claim, wherein the first protective element (5) extends longitudinally along the corresponding side (3) of the sheet (2), each first protective element (5) comprising at least one reinforcement (7).

6. The printing screen according to the preceding claim, wherein each reinforcement (7) comprises at least one projection (7b) passing through a hole (2d) of the sheet (2) cooperating with a housing (5c) comprised in the base (5a) for fixing the reinforcement (7) to the base (5a).

7. The printing screen according to any of claims 4 to 6, wherein the sheet (2) is configured for resting on the stretching device (20) along at least one support area (2b) of the sheet (2), the first corresponding protective element (5) comprising a projection (5c) extending from the base (5a) at least partially resting on the support area (2b) of the sheet (2).

8. The printing screen according to any of the preceding claims, wherein the sheet (2) has non-bent sides (4) arranged substantially parallel to one another, the printing screen (1) comprising a second protective element (6) at least partially covering each non-bent side (4) of the sheet (2).

9. The printing screen according to the preceding claim, wherein the second protective element (6) extends longitudinally along the corresponding non-bent side (4) of the sheet (2), each second protective element (6) comprising a base (6a) which is arranged on the sheet (2) and a reinforcement (11) comprising a projection (11b) passing through a hole (2e) of the sheet (2) being fixed to the base (6a).

10. The printing screen according to any of the preceding claims, comprising handling means (15) arranged in the first protective elements (5).

11. The printing screen according to the preceding claim, wherein the handling means (15) comprise a handle (16) integrated in each first protective element (5), said handles (16) being collapsible with respect to the sheet (2).

12. The printing screen according to the preceding claim, wherein each handle (16) is arranged attached to the first protective element (5) in a continuous manner through a bend line (18) acting as a hinge.

13. The printing screen according to any of the preceding claims, wherein the sheet (2) comprises all the bent sides suitable for being fastened directly to the stretching device (20).

## Patentansprüche

1. Druckschablone für Oberflächenmontagevorrichtungen, umfassend eine Folie (2), welche mindestens zwei gebogene Seiten (3) aufweist, welche im Wesentlichen parallel zueinander angeordnet sind und dazu ausgebildet sind, direkt an einer Spannvorrichtung (20) zum Spannen der Druckschablone (1) befestigt zu werden, wobei die Druckschablone (1) auf jeder gebogenen Seite (3) ein erstes Schutzelement (5) umfasst, umfassend eine Seite (5b), welche mindestens teilweise jede gebogene Seite (3) der Folie (2) deckt, und Sicherungsmittel (9, 10), welche im ersten Schutzelement (5) oder in der gebogenen Seite (3) der Folie (2) angeordnet sind und zum Halten der Druckschablone (1) gegen die Spannvorrichtung (20) und zum Zentrieren der Druckschablone (1) in Bezug auf die Spannvorrichtung (20) ausgebildet sind, **dadurch gekennzeichnet, dass** die Sicherungsmittel (9, 10) eine im Wesentlichen V-förmige Geometrie zusammen mit der gebogenen Seite (3) oder zusammen mit dem ersten Schutzelement (5) ausbilden, wobei die genannten Sicherungsmittel (9, 10) eine Verlängerung (9b, 10b) umfassen, welche sich als Fortsetzung der entsprechenden gebogenen Seite (3) erstreckt oder sich als Fortsetzung der Seite (5b) des ersten Schutzelements (5) erstreckt, wobei die Seite (5b) des ersten Schutzelements (5) im Wesentlichen parallel zur gebogenen Seite (3) der Folie (2) angeordnet ist, wenn sich die Verlängerung (10b) als Fortsetzung der Seite (5b) des ersten Schutzelements (5) erstreckt, wobei der Winkel (B, C), welcher von der Verlängerung (9b, 10b) zusammen mit der gebogenen Seite (3) gebildet ist, ein Winkel zwischen etwa 75° und etwa 130° ist, wobei die genannte Verlängerung (9b, 10b) dazu ausgebildet ist, eine fehlerhafte Montage der Druckschablone (1) in der Spannvorrichtung (20) zu verhindern.

2. Druckschablone nach Anspruch 1, wobei die Sicherungsmittel (9, 10) einen Winkel (D) mit der Folie (2) zwischen etwa 15° und etwa 100° bilden.

3. Druckschablone nach den Ansprüchen 1 oder 2, wobei jede gebogene Seite (3) einen spitzen Winkel (A) mit der Folie (2) zwischen etwa 30° und etwa 85° bildet.

4. Druckschablone nach einem der vorhergehenden Ansprüche, wobei das erste Schutzelement (5) eine Basis (5a) umfasst, welche auf der Folie (2) angeordnet ist, wobei die Seite (5b), welche eine Fortsetzung der Basis (5a) ist, auf der entsprechenden gebogenen Seite (3) der Folie (2) angeordnet ist, so dass sie mindestens teilweise die genannte gebogene Seite (3) deckt.

5. Druckschablone nach dem vorhergehenden Anspruch, wobei sich das erste Schutzelement (5) längs entlang der entsprechenden Seite (3) der Folie (2) erstreckt, wobei jedes erste Schutzelement (5) mindestens eine Verstärkung (7) umfasst.

6. Druckschablone nach dem vorhergehenden Anspruch, wobei jede Verstärkung (7) mindestens einen Vorsprung (7b) umfasst, welcher durch ein Loch (2d) der Folie (2) durchgeht, unter Zusammenwirkung mit einem Gehäuse (5c), welches in der Basis (5a) zum Fixieren der Verstärkung (7) an der Basis (5a) umfasst ist.

7. Druckschablone nach einem der Ansprüche 4 bis 6, wobei die Folie (2) dazu ausgebildet ist, auf der Spannvorrichtung (20) entlang mindestens eines Stützbereichs (2b) der Folie (2) aufzuliegen, wobei das erste entsprechende Schutzelement (5) einen Vorsprung (5c) umfasst, welches sich von der Basis (5a) erstreckt, unter mindestens teilweiser Auflage auf dem Stützbereich (2b) der Folie (2).

8. Druckschablone nach einem der vorhergehenden Ansprüche, wobei die Folie (2) nicht gebogene Seiten (4) aufweist, welche im Wesentlichen parallel zueinander angeordnet sind, wobei die Druckschablone (1) ein zweites Schutzelement (6) umfasst, unter mindestens teilweiser Deckung jeder nicht gebogenen Seite (4) der Folie (2).

9. Druckschablone nach dem vorhergehenden Anspruch, wobei sich das zweite Schutzelement (6) längs entlang der entsprechenden nicht gebogenen Seite (4) der Folie (2) erstreckt, wobei jedes zweite Schutzelement (6) eine Basis (6a), welche auf der Folie (2) angeordnet ist, und eine Verstärkung (11), welche einen Vorsprung (11b) umfasst, welcher durch ein Loch (2e) der Folie (2) durchgeht, unter Fixierung an der Basis (6a), umfasst.

10. Druckschablone nach einem der vorhergehenden Ansprüche, umfassend Handhabungsmittel (15), welche in den ersten Schutzelementen (5) angeordnet sind.

11. Druckschablone nach dem vorhergehenden Anspruch, wobei die Handhabungsmittel (15) einen Griff (16) umfassen, welche in jedem ersten Schutzelement (5) integriert ist, wobei die genannten Griffe (16) in Bezug auf die Folie (2) zusammenklappbar sind.

12. Druckschablone nach dem vorhergehenden Anspruch, wobei jeder Griff (16) mit dem ersten Schutzelement (5) durchgängig über eine Biegelinie (18), welche als Scharnier agiert, verbunden angeordnet ist.

13. Druckschablone nach einem der vorhergehenden Ansprüche, wobei die Folie (2) alle gebogene Seiten, welche dazu geeignet sind, direkt an der Spannvorrichtung (20) befestigt zu werden, umfasst.

## Revendications

1. Écran d'impression pour dispositifs de montage en surface, comprenant une feuille (2) ayant au moins deux côtés cintrés (3) disposés essentiellement parallèles entre eux, configurée pour être fixée directement à un dispositif d'étirement (20) pour étirer l'écran d'impression (1), l'écran d'impression (1) comprenant de chaque côté cintré (3) un premier élément de protection (5) comprenant un côté (5b) recouvrant au moins partiellement chaque côté cintré (3) de la feuille (2), et des moyens de fixation (9, 10) disposés dans le premier élément de protection (5) ou dans le côté cintré (3) de la feuille (2) configurée pour soutenir l'écran d'impression (1) contre le dispositif d'étirement (20) et pour centrer l'écran d'impression (1) par rapport au dispositif d'étirement (20), **caractérisée en ce que** les moyens de fixation (9, 10) configurent une géométrie essentiellement en forme de V avec le côté cintré (3) ou conjointement avec le premier élément de protection (5), lesdits moyens de fixation (9, 10) comprenant une prolongation (9b, 10b) s'étendant comme une suite du côté cintré correspondant (3) ou s'étendant comme une suite du côté (5b) du premier élément de protection (5), le côté (5b) du premier élément de protection (5) étant essentiellement disposé parallèle au côté cintré (3) de la feuille (2) lorsque la prolongation (10b) s'étend comme une suite du côté (5b) du premier élément de protection (5), l'angle (B,C) formé par la prolongation (9b, 10b) conjointement avec le côté cintré (3) étant un angle entre approximativement 75° et approximativement 130°, ladite prolongation (9b, 10b) étant configurée pour éviter un montage incorrecte de l'écran d'impression (1) dans le dispositif d'étirement (20).

2. Écran d'impression selon la revendication 1, dans lequel les moyens de fixation (9, 10) forment un angle (D) avec la feuille (2) entre approximativement 15° et approximativement 100°.

3. Écran d'impression selon les revendications 1 ou 2, dans lequel chaque côté cintré (3) forme un angle aigu (A) avec la feuille (2) entre approximativement 30° et approximativement 85°.

4. Écran d'impression selon l'une quelconque des revendications précédentes, dans lequel le premier élément de protection (5) comprend une base (5a) qui est disposée sur la feuille (2), le côté (5b) qui est une suite de la base (5a) étant disposé sur le côté cintré correspondant (3) de la feuille (2), recouvrant au moins partiellement ledit côté cintré (3).

5. Écran d'impression selon la revendication précédente, dans lequel le premier élément de protection (5) s'étend longitudinalement le long du côté correspondant (3) de la feuille (2), chaque premier élément de protection (5) comprenant au moins un renfort (7).

6. Écran d'impression selon la revendication précédente, dans lequel chaque renfort (7) comprend au moins une saillie (7b) passant à travers un trou (2d) de la feuille (2) coopérant avec un logement (5c) compris dans la base (5a) pour fixer le renfort (7b) de la base (5a).

7. Écran d'impression selon l'une quelconque des revendications 4 à 6, dans lequel la feuille (2) est configurée pour reposer sur le dispositif d'étirement (20) le long d'au moins une zone de support (2b) de la feuille (2), le premier élément de protection correspondant (5) comprenant une saillie (5c) s'étendant à partir de la base (5a) reposant au moins partiellement sur la zone de support (2b) de la feuille (2).

8. Écran d'impression selon l'une quelconque des revendications précédentes, dans lequel la feuille (2) a des côtés non cintrés (4) disposés essentiellement parallèles entre eux, l'écran d'impression (1) comprenant un deuxième élément de protection (6) recouvrant au moins partiellement chaque côté non cintré (4) de la feuille (2).

9. Écran d'impression selon la revendication précédente, dans lequel le deuxième élément de protection (6) s'étend longitudinalement le long du côté non cintré correspondant (4) de la feuille (2), chaque deuxième élément de protection (6) comprenant une base (6a) qui est disposée sur la feuille (2) et un renfort (11) comprenant une saillie (11b) passant à travers un trou (2e) de la feuille (2) étant fixée à la base (6a).

10. Écran d'impression selon l'une quelconque des revendications précédentes, comprenant des moyens de manipulation (15) disposés dans les premiers éléments de protection (5).

11. Écran d'impression selon la revendication précédente, dans lequel les moyens de manipulation (15) comprennent une poignée (16) intégrée dans chaque premier élément de protection (5), lesdites poignées (16) étant pliables par rapport à la feuille (2).

12. Écran de protection selon la revendication précédente, dans lequel chaque poignée fixée au premier élément de protection (5) d'une maniere continue à travers une ligne cintrée (18) agissant comme une charnière.

13. Écran d'impression selon l'une quelconque des revendications précédentes, dans lequel la feuille (2) comprend tous les côtés cintrés appropriés pour être fixée directement au dispositif d'étirement (20).
